# EUROPEAN PATENT APPLICATION

(11) **EP 4 231 025 A1**
(43) Date of publication of application: **23.08.2023**
(21) Application number: 21879252.1
(22) Date of filing: 28.09.2021
(51) Int. Cl.: G01R 31/367, G01R 31/396, G01R 31/387, H01M 10/44

(54) **METHOD AND APPARATUS FOR DETERMINING REMAINING CHARGING TIME, AND VEHICLE**

(30) Priority: 13.10.2020 CN 202011091613
(71) Applicant: Great Wall Motor Company Limited, Baoding, Hebei 071000 (CN)
(72) Inventor: WU, Maiqing, Baoding, Hebei 071000 (CN); LU, Na, Baoding, Hebei 071000 (CN); SONG, Dandan, Baoding, Hebei 071000 (CN); ZHANG, Chaozhi, Baoding, Hebei 071000 (CN); HAO, Yang, Baoding, Hebei 071000 (CN); SONG, Haijun, Baoding, Hebei 071000 (CN)
(74) Representative: dompatent von Kreisler Selting Werner - Partnerschaft von Patent- und Rechtsanwälten mbB
(86) International application number: PCT/CN2021/121227
(87) International publication number: WO 2022/078206

(57) **Abstract**

A method and apparatus for determining the remaining charging time, and a vehicle, which relate to the field of vehicle control. The method comprises: determining a present charging current according to a present temperature and a present single voltage of a battery (101); determining a present remaining required charging capacity of the battery according to the present available energy of the battery and the total capacity of the battery (102); and according to the present remaining required charging capacity and the present charging current, determining the remaining charging time required by the battery (103). Since a present charging current meets a requirement for a fast charging current, and also does not change linearly and is a constant charging current, the accuracy of a determined remaining charging time required by a battery is greatly improved; and the remaining charging time does not change irregularly or does not jump frequently as long as the present charging current does not change, such that a user can accurately know the remaining charging time, the user experience is improved, and a higher practical value is achieved.

## Description

### CROSS-REFERENCE TO RELATED APPLICATION

The present application claims priority to Chinese patent application No. 202011091613.2 filed on October 13, 2020 with the CNIPA, China National Intellectual Property Administration, titled "METHOD AND APPARATUS FOR DETERMINING REMAINING CHARGING TIME, AND VEHICLE", which is incorporated herein by reference in its entirety.

### TECHNICAL FIELD

The present disclosure relates to the field of vehicle control, in particular to a method and apparatus for determining remaining charging time, and a vehicle.

### BACKGROUND

At present, new energy vehicles are increasingly popular due to an improvement in environmental protection requirements, and electric vehicles powered by batteries are especially popular. However, with the popularization of electric vehicles, more and more problems occur, and how to solve these problems has become a severe test for the current new energy vehicles.

Among these problems, insufficient charging piles and long charging time are particularly significant. In order to shorten the charging time, fast charging, that is, DC charging, has emerged.

However, for the fast charging method, based on the requirement of short charging time, the charging current of the fast charging generally changes linearly and has a large current value. The charging current that changes linearly and has a large current value has a serious impact on the service life and the performance of the battery. Moreover, the remaining charging time obtained based on the charging current not only changes irregularly and is poor in accuracy, but also has frequent jumps, so that the user fails to accurately know the remaining charging time, and the user experience is poor.

### SUMMARY

The present disclosure provides a method and apparatus for determining remaining charging time, and a vehicle, which greatly improves the accuracy of the remaining charging time while meeting the charging current requirement of the fast charging.

In order to solve the above technical problem, a first aspect of embodiments of the present disclosure provides a method for determining remaining charging time, including:
determining present charging current according to a present cell voltage and a present temperature of a battery;
determining a present remaining required charging capacity of the battery according to present available energy of the battery and a total capacity of the battery; and
determining the remaining charging time required by the battery according to the present remaining required charging capacity and the present charging current;
wherein the determining present charging current according to a present cell voltage and a present temperature of a battery includes:
determining a first charging current according to the present temperature of the battery;
determining a second charging current according to the present cell voltage of the battery;
comparing the first charging current with the second charging current in terms of magnitudes, taking and correcting a smaller one to form a third charging current;
obtaining a fourth charging current by looking up a maximum temperature and maximum cell voltage table according to the temperature of the battery; and
obtaining the present charging current by comparing the third charging current with the fourth charging current in terms of magnitudes, and taking and adding the smaller one to consumption current of a high-voltage accessory.

Optionally, the determining a present remaining required charging capacity of the battery according to present available energy of the battery and a total capacity of the battery includes:
calculating a present available capacity of the battery according to the present available energy and the present cell voltage of the battery; and
determining a difference between the total capacity and the present available capacity as the present remaining required charging capacity.

Optionally, before determining a first charging current according to the present temperature of the battery, the method further includes:
setting multiple temperature ranges according to an initial temperature of the battery; and
setting a corresponding first charging current for each of the temperature ranges;
wherein, for each of the temperature ranges lower than a preset temperature threshold, when a present minimum temperature of the battery during charging rises to not lower than a corresponding first preset current value, the first charging current is changed to a fifth charging current; when the present minimum temperature of the battery during charging drops to not higher than a corresponding second preset current value, the first charging current is changed to a sixth charging current;
wherein, for each of the temperature ranges higher than the preset temperature threshold, when a present maximum temperature of the battery during charging rises to not lower than a corresponding third preset current value, the first charging current is changed to a seventh charging current; when the present maximum temperature of the battery during charging drops to not higher than a corresponding fourth preset current value, the first charging current is changed to an eighth charging current.

Optionally, before determining a second charging current according to the present cell voltage of the battery, the method further includes:
setting multiple voltage ranges according to a maximum cell voltage of the battery; and
setting a corresponding second charging current for each of the voltage ranges;
wherein, when the present maximum cell voltage of the battery during charging is lower than a corresponding first preset voltage value, the second charging current is changed to a ninth charging current;
when the present maximum cell voltage of the battery during charging is not lower than the corresponding first preset voltage value and is lower than a second preset voltage value, the second charging current is changed to a tenth charging current;
when the present maximum cell voltage of the battery is not lower than a preset voltage threshold, the second charging current is changed to zero.

Optionally, the method further includes:
setting a starting temperature range, a special temperature range and a termination temperature range according to the initial temperature of the battery; and
setting a corresponding first charging current for the staring temperature range, the special temperature range and the termination temperature range respectively;
wherein, in the starting temperature range, if the present minimum temperature of the battery is not lower than a corresponding fifth preset current value, the first charging current is changed to an eleventh charging current; if the present minimum temperature of the battery is lower than the corresponding fifth preset current value, the first charging current is changed to zero;
in the special temperature range, if the present maximum temperature of the battery is not lower than a corresponding sixth preset current value, the first charging current is changed to a twelfth charging current; if the present minimum temperature of the battery is not higher than a corresponding seventh preset current value, the first charging current is changed to a thirteenth charging current;
in the termination temperature range, if the present maximum temperature of the battery is not higher than a corresponding eighth preset current value, the first charging current is changed to a fourteenth charging current; if the present maximum temperature of the battery is higher than the corresponding eighth preset current value, the first charging current is changed to zero.

A second aspect of embodiments of the present disclosure provides an apparatus for determining remaining charging time, including:
a present charging current determination module, configured to determine present charging current according to a present cell voltage and a present temperature of a battery;
a present remaining required charging capacity determination module, configured to determine a present remaining required charging capacity of the battery according to present available energy of the battery and a total capacity of the battery; and
a remaining charging time determination module, configured to determine the remaining charging time required by the battery according to the present remaining required charging capacity and the present charging current.
wherein the present charging current determination module includes:
a first determination unit, configured to determine a first charging current according to the present temperature of the battery;
a second determination unit, configured to determine a second charging current according to a present cell voltage of the battery;
a comparison and correction unit, configured to compare the first charging current with the second charging current in terms of magnitudes, take and correct a smaller one to form a third charging current;
a table look-up unit, configured to obtain a fourth charging current by looking up a maximum temperature and maximum cell voltage table according to the temperature of the battery; and
a charging current determination unit, configured to obtain the present charging current by comparing the third charging current with the fourth charging current in terms of magnitudes, and taking and adding a smaller one with consumption current of a high-voltage accessory.

Optionally, the present remaining required charging capacity determination module includes:
a capacity calculation unit, configured to calculate a present available capacity of the battery according to present available energy and the present cell voltage of the battery; and
a difference unit, configured to determine a difference between the total capacity and the present available capacity as the present remaining required charging capacity.

Optionally, the apparatus further includes:
a temperature range setting module, configured to set multiple temperature ranges according to an initial temperature of the battery; and
a temperature range current setting module, configured to set a corresponding first charging current for each of the temperature ranges;
wherein, for each of the temperature ranges lower than a preset temperature threshold, when the present minimum temperature of the battery during charging rises to not lower than a corresponding first preset current value, the first charging current is changed to a fifth charging current; when the present minimum temperature of the battery during charging drops to not higher than a corresponding second preset current value, the first charging current is changed to a sixth charging current;
wherein, for each of the temperature ranges higher than the preset temperature threshold, when the present maximum temperature of the battery during charging rises to not lower than a corresponding third preset current value, the first charging current is changed to a seventh charging current; when the present maximum temperature of the battery during charging drops to not higher than a corresponding fourth preset current value, the first charging current is changed to an eighth charging current.

Optionally, the apparatus further includes:
a voltage range setting module, configured to set multiple voltage ranges according to a maximum cell voltage of the battery; and
a voltage range current setting module, configured to set a corresponding second charging current for each of the voltage ranges;
wherein, when the present maximum cell voltage of the battery during charging is lower than a corresponding first preset voltage value, the second charging current is changed to a ninth charging current;
when the present maximum cell voltage of the battery during charging is not lower than the corresponding first preset voltage value and is lower than a second preset voltage value, the second charging current is changed to a tenth charging current;
when the present maximum cell voltage of the battery is not lower than a preset voltage threshold, the second charging current is changed to zero.

A third aspect of the embodiments of the present disclosure provide a vehicle including a vehicle controller,
wherein the vehicle controller executes any one of the methods for determining remaining charging time.

According to the method for determining charging time provided by the present disclosure, the present charging current is determined according to the present cell voltage and the present temperature of the battery, and the present remaining required charging capacity of the battery is determined according to the present available energy of the battery and the total capacity of the battery; the remaining charging time required by the battery is determined according to the present remaining required charging capacity and the present charging current. Since the first charging current is determined according to the present temperature of the battery, the second charging current is determined according to the cell voltage of the battery, and then the first charging current and the second charging current are compared in terms of magnitudes, and the smaller one is taken and corrected to form the third charging current; on the basis of the third charging current, the maximum temperature and the maximum cell voltage table is looked up according to the battery temperature to get the fourth charging current, then the third charging current is compared with the fourth charging current in terms of magnitudes, the smaller one is taken and added to the current consumption of high voltage accessories to obtain the present charging current at the present temperature.

Since the present charging current is no longer a linear change but a constant charging current while meeting the requirements for fast charging current, compared with the remaining charging time obtained based on the linearly changing current, the accuracy of the remaining charging time required for the battery, which is determined according to the present remaining required charging capacity and the present charging current, is greatly improved. Moreover, as long as the present charging current remains unchanged, the remaining charging time will not change irregularly, nor will it change frequently, so that the user can accurately know the remaining charging time, which improves the user experience and has high practical value.

The above description is only a summary of solutions of the present disclosure. In order to make technical means of the present disclosure be better understood and implemented according to the disclosure of the description, and in order to make the above and other objects, features and advantages of the present disclosure more apparent and understandable, specific embodiments of the present disclosure are illustrated below.

### BRIEF DESCRIPTION OF THE DRAWINGS

In order to clearly explain technical solutions of embodiments of the present disclosure, drawings that are required for describing the embodiments are briefly introduced below. Apparently, the drawings in the following description are only some embodiments of the present disclosure. For those skilled in the art, other drawings can be obtained based on these drawings without paying creative work.
FIG. 1 is a flowchart of a method for determining remaining charging time according to an embodiment of the present disclosure;
FIG. 2 is a flowchart of a method for determining current charging current in an embodiment of the present disclosure;
FIG. 3 is an example diagram illustrating specific temperature ranges and charging current value settings in an embodiment of the present disclosure;
FIG. 4 is an example diagram illustrating specific voltage ranges and charging current value settings in an embodiment of the present disclosure;
FIG. 5 is a block diagram illustrating an apparatus for determining remaining charging time according to an embodiment of the present disclosure;
FIG. 6 is a block diagram schematically illustrating a computing processing device for performing the method according to the present disclosure; and
FIG. 7 schematically shows a storage unit for holding or carrying program codes implementing the method according to the present disclosure.

### DETAILED DESCRIPTION

The technical solutions of the embodiments of the present application will be clearly and thoroughly described below with reference to the accompanying drawings of the embodiments of the present application. Apparently, only a part of the embodiments, not all the embodiments of the present application, are described. All other embodiments obtained, based on the embodiments described in the present application, by those skilled in the art without paying creative efforts shall fall within the protection scope of the present application.

The inventor found that various factors need to be considered in setting the current of the fast charging at present. Based on the requirement of short charging time, the charging current of fast charging generally changes linearly and has a large current value. However, the charging current that changes linearly and has a large current value may exceed an upper limit of the charging current allowed under factor of the current temperature of the battery, or may exceed an upper limit of the charging current allowed under factor of the current cell voltage of the battery. Moreover, the linear change of the charging current is not stable, and will represent changes in which the current value becomes larger and smaller repeatedly, instead of representing continuously increasing or continuously decreasing.

Accordingly, the above conditions will not only have a serious impact on the service life and performance of the battery, resulting in shorter service life and poor performance of the battery, but also cause the remaining charging time obtained based on the charging current to change irregularly and be poor in accuracy, resulting in frequent jumps of the remaining charging time. As a result, the user fails to accurately know the remaining charging time, and the experience is very poor.

In view of the above problems, the inventor has conducted a lot of research, calculation, simulation and field tests, and creatively proposed the method for determining remaining charging time of the present disclosure. The technical solution of the present disclosure is described and illustrated in detail below.

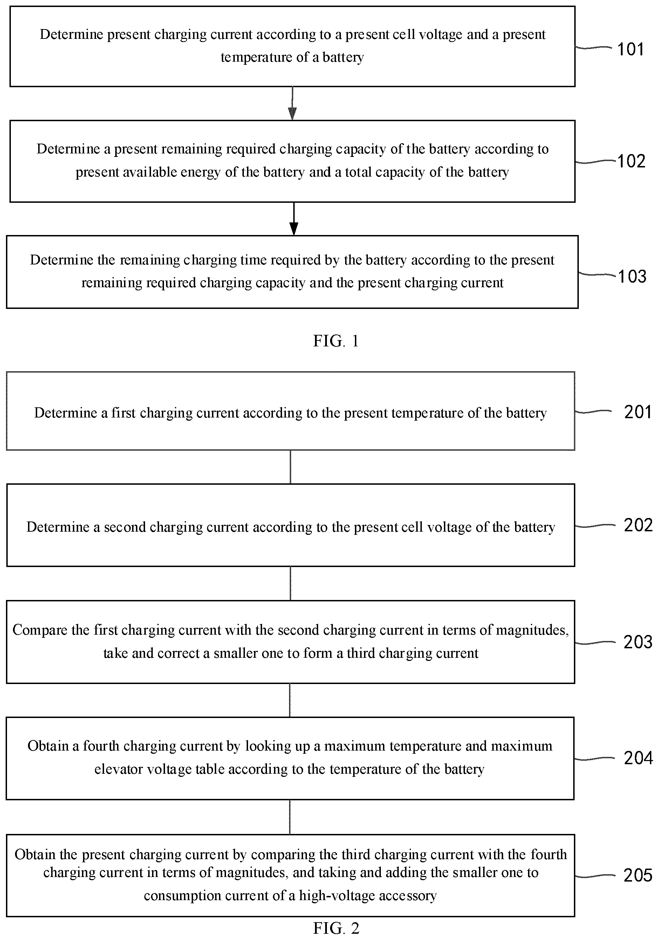

FIG. 1 is a flowchart of a method for determining remaining charging time according to an embodiment of the present disclosure. The method includes steps described below.

At step 101, present charging current is determined according to a present temperature and present cell voltage of the battery.

In embodiments of the present disclosure, before or during a charging process of an electric vehicle, the temperature and the cell voltage of the battery generally do not change abruptly, and may only rise or fall slowly. Generally, in order to ensure the performance and service life of the battery, a separate heating and/or cooling device is provided for the battery in the electric vehicle so that the battery can work under a better temperature condition. However, in actual applications, before the battery is charged, the temperature of the battery may be at various temperatures due to various factors such as an external environment, driving habits, and road conditions, that is, an initial temperature of the battery before charging is widely dispersed.

Generally, the temperature and the cell voltage of the battery are two key factors affecting the charging current of the battery. Therefore, embodiments of the present disclosure propose a new method for determining the charging current according to the temperature and the cell voltage of the battery, in which multiple temperature ranges are divided according to the initial temperature of the battery, and multiple voltage ranges are divided according to the highest cell voltage of the battery, so that the present charging current of the battery can be determined according to the present temperature and the present cell voltage of the battery. The method of determining the charging current according to the battery temperature and the cell voltage of the battery is explained below, and will not be repeated here.

At step 102, present remaining required charging capacity of the battery is determined according to present available energy of the battery and a total capacity of the battery.

In the embodiments of the present disclosure, besides that the present charging current of the battery is determined, the present remaining required charging capacity of the battery also needs to be determined. The so-called present remaining required charging capacity is the capacity required to be charged until the battery is charged to the total capacity of the battery from the present capacity, that is, the difference between the total capacity of the battery and the present available capacity of the battery. In general, the vehicle controller or battery management system directly obtains the present available energy of the battery, the unit of which is KwH. Therefore, it is necessary to perform a division operation first based on the present available energy and the present voltage of the battery, so as to obtain the present available capacity of the battery, that is, the present available capacity of the battery = the present available energy of the battery/the present voltage of the battery; the present remaining required charging capacity of the battery = the total capacity of the battery - the present available capacity of the battery.

For example, assuming that the total capacity of the battery is 156AH, the present available energy of the battery is 180KwH, and the present cell voltage of the battery is 3V, then the present available capacity of the battery = 180KwH/3V = 60AH, and the present remaining required charging capacity of the battery=156AH-60AH=96AH.

At step 103, the remaining charging time required by the battery is determined according to the present remaining required charging capacity and the present charging current.

In the embodiments of the present disclosure, once the present remaining required charging capacity of the battery and the present charging current of the battery are determined, the remaining charging time required by the battery can be obtained only by dividing the present remaining required charging capacity by the present charging current. Since the present charging current of the battery is constant, the determined remaining charging time required by the battery is also accurate and will not change irregularly or have frequent jumps. The remaining charging time required by the battery will change only after the battery's present charging current changes.

Following the above example, if the charging current of the battery determined under conditions of the present temperature and the present cell voltage is 118A, then the remaining charging time required by the battery=96AH/118A=0.814H=48.84min. The user can intuitively know the remaining charging time, and as long as the present charging current does not change, the remaining charging time is accurate and gradually decreases regularly without frequent jumps.

Assuming that the present temperature of the battery or the cell voltage changes, and the charging current determined under the changed conditions becomes 100A, since the battery has been charged at 118A for a period of time, when the charging current changes to 100A, it is necessary to recalculate the present remaining required charging capacity of the battery when the charging current changes to 100A. Assuming that the present remaining required charging capacity is 50AH, then the remaining charging time required by the battery at this time will change, the value of the remaining charging time=50AH/100A=0.5H=30min.

Optionally, in the embodiments of the present disclosure, the specific steps of step 101 in which the present charging current is determined according to the present temperature of the battery are as follows.

Referring to FIG. 2, it shows a flowchart of a method for determining the present charging current in the embodiment of the present disclosure.

At step 202, a first charging current is determined according to the present temperature of the battery.

In the embodiment of the present disclosure, before the electric vehicle is charged, that is, before the electric vehicle is connected to a direct current (DC) charging pile, the first charging current is determined according to the temperature of the battery first. The so-called first charging current is an allowable upper limit value of the charging current based on the present temperature of the battery.

In the embodiment of the present disclosure, in order to further accurately determine the allowable upper limit value of the charging current based on the present temperature of the battery, the inventor creatively proposed the following idea:

Multiple temperature ranges are set according to the initial temperature of the battery, and then a corresponding first charging current is set for each of the temperature ranges. That is, multiple temperature ranges are set according to the present temperature of the battery when it is about to be charged. Due to the particularity of the battery, temperature is a key and sensitive factor. In general, based on the working efficiency, service life, performance and other factors of the battery, the electric vehicle is provided with air conditioners, fans and other equipment to heat and cool the battery, so as to maintain the temperature of the battery. However, in practice, due to factors such as environment temperature and working status, the battery temperature will inevitably have various magnitudes. Therefore, it is necessary to set multiple temperature ranges based on the present temperature of the battery, that is, the initial temperature. Moreover, for each of the temperature range and in view of various factors in the charging process, the inventor has also made a more detailed and targeted distinction, and the detailed technical solution is explained below, which will not repeated here.

At step 202, a second charging current is determined according to the present cell voltage of the battery.

In the embodiment of the present disclosure, similarly, before the electric vehicle is charged, that is, before the electric vehicle is connected to a DC charging pile, the second charging current needs to be determined according to the cell voltage of the battery. The so-called second charging current is an allowable upper limit value of the charging current based on the present cell voltage of the battery.

In the embodiment of the present disclosure, in order to further accurately determine the allowable upper limit value of the charging current based on the present cell voltage of the battery, the inventor creatively proposed the following idea:

Multiple temperature ranges are set according to the maximum cell voltage of the battery, and then a corresponding second charging current is set for each of the temperature ranges. That is, multiple temperature ranges are set according to the present maximum cell voltage when the battery is about to be charged. Due to the particularity of the battery, the maximum cell voltage is also a key and sensitive factor. In general, battery modules are used in the electric vehicle, and the battery module includes multiple cells. Based on various factors such as the working efficiency, service life, performance, and manufacturing process of the battery, the cell voltage of each battery may vary slightly. However, in practice, due to factors such as manufacturing process and working status, with the increase of usage time, the cell voltage of each battery will inevitably change, and the voltage difference between them may increase. Further, the voltage of the battery when it is fully charged is generally the allowable upper limit of the voltage, and the voltage of the battery will naturally drop after a period of use. Similarly, the voltage of battery before it is charged will be relatively low, and the voltage of the battery will gradually increase as the charging proceeds, and the individual cell voltage value of each battery is different. Therefore, it is necessary to set multiple temperature ranges based on the present maximum cell voltage of the battery. Moreover, for each of the temperature ranges and in view of factors such as voltage rise during charging, the inventor has also carried out more detailed and targeted distinction, and the detailed technical solutions are explained below, which will not be repeated here.

At step 203, the first charging current is compared with the second charging current in terms of magnitudes, a smaller one is taken and corrected to form a third charging current.

In the embodiment of the present disclosure, after the first charging current and the second charging current are determined, the first charging current is compared with the second charging current in terms of magnitudes, and the smaller one between the two is taken and corrected to form the third charging current. The so-called correction is to, after acquiring the smaller one of the first charging current and the second charging current, subtract a calibration value from the smaller one to further reduce the charging current, and the smaller one after correction is the third charging current. The reason for the correction is that the temperature value of the battery is an estimated value, which is not very accurate, and there are inevitable errors in the maximum value of the cell voltage although it is actually measured. In order to eliminate the problem that the charging current value may be too high caused by the inaccurate estimation and the measurement error, a calibration value is proposed. The calibration value is a classic value obtained through a large number of calculations, simulations and actual measurements, thereby ensuring to eliminate the problem that the charging current value may be too high caused by the inaccurate estimation and the measurement error, and also ensuring to meet the required magnitude of the charging current of the fast charging. Therefore, after comparing the magnitudes of the first charging current and the second charging current and taking a smaller one, correction is made to form the third charging current.

It is naturally understandable that, if it is determined that the value of the first charging current is smaller after comparing the first charging current with the second charging current, then the difference between the value of the first charging current and the calibration value forms the third charging current; if it is determined that the value of the second charging current is smaller after comparing the first charging current wit the second charging current, the difference between the value of the second charging current and the calibration value forms the third charging current.

At step 204, a fourth charging current is obtained by looking up a maximum temperature and maximum cell voltage table according to the battery temperature.

In the embodiment of the present disclosure, after the third charging current is determined, it is also necessary to look up the maximum temperature and maximum cell voltage table according to the present temperature of the battery to obtain the fourth charging current. The maximum temperature and maximum cell voltage table is a table of the charging current corresponding to the currently known battery temperature. The charging current obtained based on the table is the upper limit value allowed at the present temperature, which is also a linearly changing value. The upper limit value of the charging current at the present temperature of the battery can be obtained through this table.

At step 205, the third charging current is compared with the fourth charging current in terms of magnitudes, the smaller one is taken and added to consumption current of the high-voltage accessory to obtain the present charging current.

In the embodiment of the present disclosure, after the third charging current and the fourth charging current are determined, the third charging current is further compared with the fourth charging current in terms of magnitudes, and the smaller one of the two is taken and added to the consumption current of the high-voltage accessory, and the charging current required for the present charging of the battery, that is, the present charging current is finally obtained.

In the embodiment of the present disclosure, since the third charging current has integrated the factors of the present battery temperature and the present maximum cell voltage, the third charging current will not exceed the upper limit value of the charging current under the factors of battery temperature and cell voltage. Then, after the third charging current with the fourth charging current and the smaller one is taken, the problem that the charging current determined is too high caused by all other possible factors is further eliminated, and the value of the charging current of the fast charging is accurate. Therefore, while meeting the charging current requirements of the fast charging, the charging current will not only not exceed the upper limit of the charging current under the factors of battery temperature and cell voltage, but also the charging current is a constant charging current. The charging current will not exceed the upper limit of the charging current allowed under the factor of the present temperature of the battery, and will not exceed the upper limit of the charging current allowed under the factor of the present cell voltage of the battery, and there is no problem of repeated changes in the current value of the charging current, which makes the impacts of fast charging on the service life and performance of the battery minimum.

It should be noted that after the charging current required for charging the battery is finally obtained, the value of the charging current needs to be sent to a charging device such as charging piles, so that the electric vehicle starts to be charged. During the charging process, as the battery temperature and cell voltage change, the charging current can be automatically re-determined according to the technical solutions in the above steps 201~205. It can be understood that, during the charging process, the temperature and the cell voltage of the battery change slowly and cannot change abruptly. Therefore, as long as the present temperature and the present maximum cell voltage of the battery are still in the present range, the charging current will basically not change, that is, the charging current has a constant value. Only when the present temperature or the present maximum cell voltage of the battery changes to other ranges, the charging current may change to other values. After the charging current changed to other values, the battery will be charged with this value until the present temperature or the present maximum cell voltage of the battery changes to other ranges again, that is, the charging current will not get greater or smaller.

Hereinafter, a technical solution, in which multiple temperature ranges are set according to the initial temperature of the battery, and a technical solution, in which multiple voltage ranges are set according to the maximum cell voltage of the battery, in the embodiment of the present disclosure will be explained in detail respectively.

For the initial temperature of the battery, due to the characteristics of the battery, it is necessary to set a starting temperature range, a special temperature range, a termination temperature range and a normal temperature range.

The so-called starting temperature range means that the battery is allowed to be charged only when the present minimum temperature of the battery is higher than a certain temperature value, and the battery is not allowed to be charged when the present minimum temperature of the battery is lower than the certain temperature value, which is to protect the battery. For example, it is currently known that the battery is not allowed to be charged if the initial minimum temperature of the battery is lower than -20°C, otherwise the service life and performance of the battery will be seriously affected. Therefore, it is necessary to set the starting temperature range.

The so-called special temperature range means a temperature range, in which if the temperature rises, it needs to consider of changing the charging current when the maximum temperature of the battery is not less than a certain value, and if the temperature is decreased, it needs to consider of changing the charging current when the minimum temperature of the battery is not greater than a value. For example, as currently known, 15°C is a relatively special value. When the maximum temperature of the battery is not lower than 15°C, the charging current needs to be considered according to the maximum temperature of the battery; when the maximum temperature of the battery is lower than 15°C, the charging current needs to be considered according to the minimum temperature of the battery. This value is also a preset temperature threshold.

The so-called termination temperature range means that the battery is not allowed to be charged after the present maximum temperature of the battery is higher than a certain temperature value, and the battery is allowed to be charged only when the present maximum temperature is not higher than this value. This is also to protect the battery. For example, as currently known, if the initial maximum temperature of the battery is higher than 55°C, the battery is not allowed to be charged, otherwise the service life and performance of the battery will be seriously affected. Therefore, it is necessary to set the termination temperature range.

The so-called normal temperature range refers to a temperature range other than the starting temperature range, the special temperature range and termination temperature range. For each temperature range below the preset temperature threshold, the battery temperature may rise during charging, and when the minimum temperature of the battery rises to not lower than a corresponding first preset current value, the first charging current is changed as a fifth charging current; and the battery temperature may also decrease during charging, when the minimum temperature of the battery drops to not higher than a corresponding second preset current value, the first charging current is changed as a sixth charging current.

For each temperature range above the preset temperature threshold, the battery temperature may rise during charging, and when the maximum temperature of the battery rises to not lower than a corresponding third preset current value, the first charging current is changed as a seventh charging current; and the battery temperature may also decrease during charging, when the maximum temperature of the battery drops to not higher than a corresponding fourth preset current value, the first charging current is changed as an eighth charging current.

In the embodiments of the present disclosure, for the starting temperature range, if the minimum temperature of the battery is not lower than the corresponding fifth preset current value, the first charging current is changed as an eleventh charging current; if the minimum temperature of the battery is lower than the corresponding fifth preset current value, the first charging current is changed to zero; for the special temperature range, if the maximum temperature of the battery is not lower than a corresponding sixth preset current value, the first charging current is changed as a twelfth charging current; if the minimum temperature of the battery is not higher than a corresponding seventh preset current value, the first charging current is changed as a thirteenth charging current; for the termination temperature range, if the maximum temperature of the battery is not higher than a corresponding eighth preset current value, the first charging current is changed as a fourteenth charging current; if the maximum temperature of the battery is higher than the corresponding eighth preset current value, the first charging current is changed to zero.

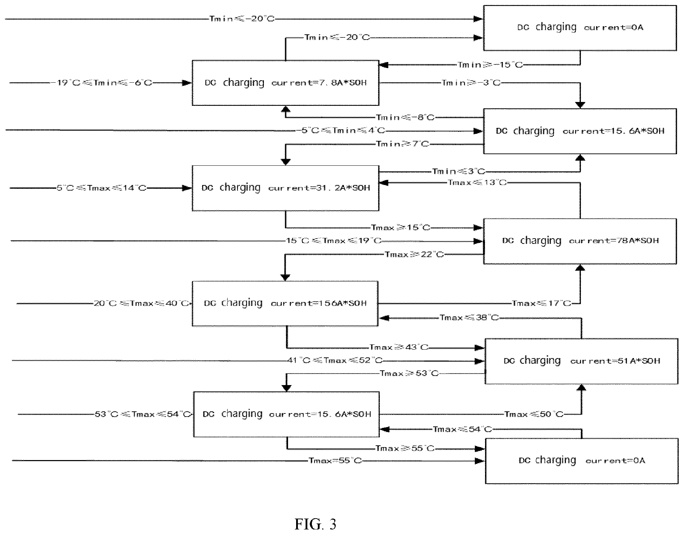

The above solution of setting, for the initial temperature of the battery, multiple temperature ranges and the charging current of each temperature range can be further clearly explained in conjunction with FIG. 3. FIG. 3 is an example diagram illustrating specific temperature ranges and charging current value settings in an embodiment of the present disclosure.
1) If the minimum initial temperature of the battery is lower than -20° C (Tmin≤ -20° C in FIG. 3), then the charging current based on this temperature range is set to be 0A (DC charging current=0A in FIG. 3), that is, the battery is not allowed to be charged; if the temperature of the battery rises later, the charging current is changed as 7.8A*SOH (DC charging current=7.8A*SOH in FIG. 3) when the minimum value of the present temperature of the battery is not lower than -15° C (Tmin≥-15° C in FIG. 3), wherein SOH is the abbreviation of state of heath.
2) If the initial temperature of the battery is located in [-19° C, -6° C] (-19° C≤Tmin ≤-6° C in FIG. 3), then the charging current based on this temperature range is set to be 7.8A*SOH (DC charging current=7.8A*SOH in FIG. 3); if the temperature of the battery rises later, the charging current is changed as 15.6A*SOH (DC charging current=15.6A* SOH in FIG. 3) when the minimum value of the present temperature of the battery is not less than -3 ° C (Tmin≥-3° C in FIG. 3); similarly, if the temperature of the battery drops, the charging current is changed as 0 (DC charging current=0A in FIG. 3) when the minimum value of the present temperature of the battery is not greater than -20° C (Tmin≤-20° C in FIG. 3).
3) If the initial temperature of the battery is located in [-5°C, 4°C], then the charging current based on this temperature range is set to be 15.6A*SOH (DC charging current=15.6A*SOH in FIG. 3); if the temperature of the battery rises later, when the minimum value of the present temperature of the battery is not less than 7° C (Tmin≥7° C in FIG. 3), the charging current is changed as 31.2A*SOH (DC charging current=31.2A*SOH in FIG. 3); similarly, if the temperature of the battery drops, the charging current is changed as 7.8A*SOH (DC charging current=7.8A* SOH in FIG.3 ) when the minimum value of the present temperature of the battery is not higher than -8° C (Tmin≤-8° C in FIG. 3).
4) If the initial temperature of the battery is located in [5°C, 14°C], the charging current based on this temperature range is set to be 31.2A*SOH (DC charging current=31.2A*SOH in FIG. 3); if the temperature of the battery rises later, the charging current is changed as 78A*SOH (DC charging current=78A*SOH in FIG. 3) when the maximum value of the present temperature of the battery is not lower than 15° C (Tmax≥15° C in FIG. 3); similarly, if the temperature of the battery drops, the charging current is changed as 15.6A*SOH (DC charging current=15.6A*SOH in FIG. 3) when the minimum value of the present temperature of the battery is not higher than 3° C (Tmin≤3° C in FIG. 3).
5) If the initial temperature of the battery is located in [15°C, 19°C], then the charging current based on this temperature range is set to be 78A*SOH (DC charging current=78A*SOH in FIG. 3); if the temperature of the battery rises later, the charging current is changed as 156A*SOH (DC charging current=156A*SOH in FIG. 3) when the maximum value of the present temperature of the battery is not lower than 22° C (Tmax≥22° C in FIG. 3); similarly, if the temperature of the battery drops, the charging current is changed as 31.2A*SOH (DC charging current=31.2A*SOH in FIG. 3 ) when the maximum value of the present temperature of the battery is not higher than 13° C (Tmax≤13° C in FIG. 3).
6) If the initial temperature of the battery is located in [20°C, 40°C], then the charging current based on this temperature range is set to be 156A*SOH (DC charging current=156A*SOH in FIG. 3); if the temperature of the battery rises later, the charging current is changed as 51A*SOH (DC charging current=51A*SOH in FIG. 3) when the maximum value of the present temperature of the battery is not lower than 43° C (Tmax≥43° C in FIG. 3); similarly, if the temperature of the battery drops, the charging current is changed as 78A*SOH (DC charger current=78A*SOH in FIG. 3) when the maximum value of the present temperature of the battery is not higher than 17° C (Tmax≤17° C in FIG. 3).
7) If the initial temperature of the battery is located in [41°C, 52°C], the charging current based on this temperature range is set to be 51A*SOH (DC charging current=51A*SOH in FIG. 3); if the temperature of the battery rises later, the charging current is changed as 15.6A*SOH (DC charging current=15.6A*SOH in FIG. 3) when the maximum value of the present temperature of the battery is not lower than 53° C (Tmax≥53° C in FIG. 3); similarly, if the temperature of the battery drops, the charging current is changed as 156A*SOH (DC charging current=156A*SOH in FIG. 3) when the maximum value of the present temperature of the battery is not higher than 38° C (Tmax≤38° C in FIG. 3).
8) If the initial temperature of the battery is located in [53°C, 54°C], then the charging current based on this temperature range is set to be 15.6A*SOH (DC charging current=15.6A*SOH in FIG. 3); if the temperature of the battery rises later, the charging current is changed as 0A (DC charging current=0A in FIG. 3) when the maximum value of the present temperature of the battery is not lower than 55° C (Tmax≥55° C in FIG. 3); similarly, as the battery temperature decreases, the charging current is changed as 51A*SOH (DC charging current=51A*SOH in FIG. 3) when the maximum value of the present temperature of the battery is not higher than 50° C (Tmax≤50° C in FIG. 3).
9) If the maximum initial temperature of the battery is equal to 55°C (Tmax=55°C in FIG. 3), then the charging current based on this temperature range is set to be 0 (DC charging current=0A in FIG. 3), that is, the battery is not allowed to be charged, and it is required to cool the battery; similarly, if the temperature of the battery drops, the charging current is changed as 15.6A*SOH (DC charging current=15.6A*SOH in FIG. 3) when the maximum value of the present temperature of the battery is not higher than 54° C (Tmax≤54° C in FIG. 3).

Among the above nine temperature ranges, the temperature range in which the minimum initial temperature of the battery is lower than -20°C is the starting temperature range, the temperature range in which the initial temperature of the battery is located in [5°C, 14°C] is the special temperature range, the temperature range in which the maximum initial temperature of the battery is equal to or above 55°C is the termination temperature range, and the rest are normal temperature ranges. It needs to be further explained here, under normal circumstances, when the temperature of the battery enters the range [20°C, 40°C], the battery management system will activate the thermal management mechanism to control the temperature of the battery, so that the battery remains within this temperature range, and will not change to other temperature ranges. Of course, it can be understood that if the temperature of the battery exceeds this temperature range due to other factors, it is necessary to cool the battery first so that the temperature of the battery drops to this range. For example, the initial temperature of the battery is in the range of [41°C, 52°C]. In the case, although the battery will still be charged, the battery management system will also control its temperature. In the range of [41°C, 52°C], first, the charging current will still be determined according to the method for determining the charging current above and the battery is charged, until the temperature of the battery drops to the range of [20°C, 40°C], and the battery maintains in the range. Similarly, if the initial temperature of the battery is low, the temperature of the battery rises to the range of [20°C, 40°C] during the charging process, then it will maintain in this range.

For the cell voltage of the battery, due to the characteristics of the battery, the cell voltage of the battery will increase with the charging, so multiple voltage ranges are set according to the maximum cell voltage of the battery, and a corresponding second charging current is set for each of the voltage ranges.

When the maximum cell voltage of the battery during charging is lower than a corresponding first preset voltage value, the second charging current is changed to the ninth charging current; and when the maximum cell voltage of the battery during charging is not lower than the corresponding first preset voltage value and lower than a second preset voltage value, the second charging current is changed to the tenth charging current. There is also a special case, when the maximum cell voltage of the battery is not lower than a preset voltage threshold, the second charging current is changed to zero. For example, the preset voltage threshold of the battery is 4.2V, then the battery is not allowed to be charged when the maximum cell voltage of the battery reaches 4.2V.

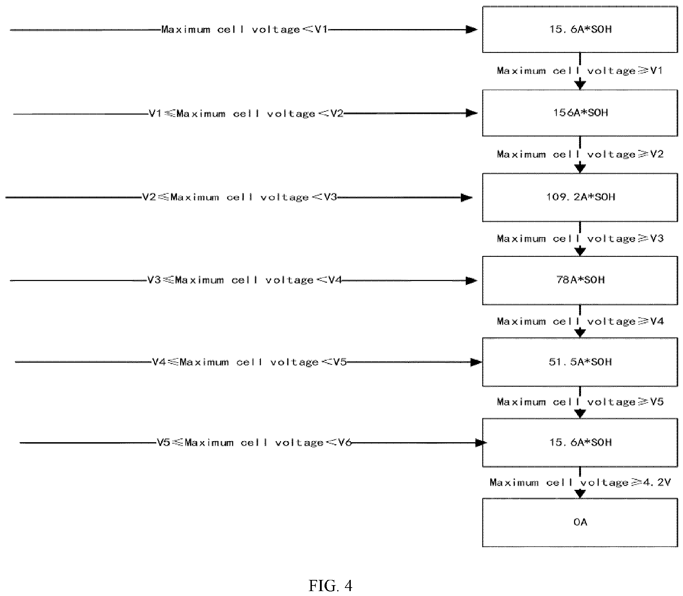

The above method of setting multiple voltage ranges for the maximum cell voltage of the battery and setting the charging current for each voltage range can be further clearly explained in conjunction with FIG. 4. FIG. 4 is an example diagram illustrating specific voltage ranges and charging current value settings in an embodiment of the present disclosure.

According to the maximum cell voltage of the battery, seven voltage ranges are set: a voltage range where the maximum cell voltage is lower than V1 (Maximum cell voltage<V1 in FIG. 4); a voltage range where the maximum cell voltage is not lower than V1 and lower than V2 (V1≤Maximum cell voltage<V2 in FIG. 4); a voltage range where the maximum cell voltage is not lower than V2 and lower than V3 (V2≤Maximum cell voltage<V3 in FIG. 4); a voltage range where the maximum cell voltage is not lower than V3 and lower than V4 (V3≤ Maximum cell voltage<V4 in FIG. 4); a voltage range where the maximum cell voltage is not lower than V4 and lower than V5 (V4≤Maximum cell voltage<VS in FIG. 4); a voltage range where the maximum cell voltage is not lower than V5 and lower than V6 (V5≤Maximum cell voltage<V6 in FIG. 4); and a voltage range where the maximum cell voltage is not lower than 4.2V (Maximum cell voltage ≥ 4.2 in FIG. 4).

The values of V1, V2, V3, V4, V5, and V6 are shown in a table below.

| | |
|---|---|
| V1 | 3.2V |
| V2 | 3.875V |
| V3 | 4.13V |
| V4 | 4.14 V |
| V5 | 4.15 V |
| V6 | 4.16 V |

When the present maximum cell voltage of the battery is the voltage range lower than V1 (Maximum cell voltage<V1 in FIG. 4), the charging current based on this voltage range is set to be 15.6 A (15.6A*SOH in FIG. 4); when the present maximum cell voltage of the battery is in the voltage range lower than V1 and lower than V2 (V1≤Maximum cell voltage<V2 in FIG. 4), or when the present maximum cell voltage of the battery rises to the voltage range not lower than V1 and lower than V2 (V1≤Maximum cell voltage<V2 in FIG. 4) with the charging, the charging current based on this voltage range is changed to 156 A (156A*SOH in FIG. 4); when the present maximum cell voltage of the battery is in the voltage range lower than V2 and lower than V3 (V2≤Maximum cell voltage<V3 in FIG. 4), or when the present maximum cell voltage of the battery rises to the voltage range not lower than V2 and lower than V3 (V2≤Maximum cell voltage<V3 in FIG. 4) with the charging, the charging current based on this voltage range is changed to 109.2 A (109.2A*SOH in FIG. 4).

When the present maximum cell voltage of the battery is in the voltage range lower than V3 and lower than V4 (V3≤Maximum cell voltage<V4 in FIG. 4), or when the present maximum cell voltage of the battery rises to the voltage range not lower than V3 and lower than V4 (V3≤Maximum cell voltage<V4 in FIG. 4) with the charging, the charging current based on this voltage range is changed to 78 A (786A*SOH in FIG. 4); when the present maximum cell voltage of the battery is in the voltage range lower than V4 and lower than V5 (V4≤Maximum cell voltage<V5 in FIG. 4), or when the present maximum cell voltage of the battery rises to the voltage range not lower than V4 and lower than V5 (V4≤Maximum cell voltage<V5 in FIG. 4) with the charging, the charging current based on this voltage range is changed to 51.5A (51.5A*SOH in FIG. 4).

When the present maximum cell voltage of the battery is in the voltage range lower than V5 and lower than V6 (V5≤Maximum cell voltage<V6 in FIG. 4), or when the present maximum cell voltage of the battery rises to the voltage range not lower than V5 and lower than V6 (V5≤Maximum cell voltage<V6 in FIG. 4) with the charging, the charging current based on this voltage range is changed to 15.6 A (15.6A*SOH in FIG. 4); when the present maximum cell voltage of the battery is in the voltage range not lower than 4.2V (Maximum cell voltage ≥ 4.2 in FIG. 4), or when the present maximum cell voltage of the battery rises to the voltage range not less than 4.2V (Maximum cell voltage ≥ 4.2 in FIG. 4) with the charging, the charging current based on this voltage range is changed to 0A (0A in FIG. 4).

In combination with the above example, a simple instance is given to illustrate the method for determining the current charging current in the embodiment of the present disclosure. Assuming that the initial temperature of the battery when being charged is 26°C, that is, the present temperature of the battery is 26°C, and the present maximum cell voltage is 3.98V, then according to the initial temperature of 26°C, it is in the temperature range of [20°C, 40°C], and the charging current should be set as 156A*SOH; on the other hand, according to the present maximum cell voltage of 3.98V, it is in a voltage range not lower than 3.875V and lower than 4.13V, and the charging current should be set as 109.2A*SOH. Then, the two charging currents are compared in terms of magnitudes and the smaller one is acquired, that is, the charging current should be 109.2 A*SOH. Next, the charging current is corrected, assuming that the calibration value is 1.2, then the corrected charging current is 108 A*SOH. Then, the maximum temperature and the maximum cell voltage table is looked up according to the present battery temperature of 26°C to obtain a corresponding charging current of 156 A*SOH, and the charging current of 156 A*SOH is compared with the charging current of 108 A*SOH to acquire the smaller one, that is, the charging current is 108 A*SOH. Next, the charging current of 108 A*SOH is added to the consumption current of high-voltage accessories. Assuming that the current consumption of high-voltage accessories is 10A*SOH, then the present charging current required for charging the battery is finally 118 A*SOH, and this value can be sent to the charging pile.

The charging pile charges the battery with the charging current of 118A*SOH. Assuming that the present available energy of the battery is 70KwH, that is, the available energy of the battery before charging is 70KwH, and the total capacity of the battery is 156AH, then the present available capacity of the battery is calculated, according to the present cell voltage of the battery of 3.98V, as 70KwH/3.98V=17.588AH. Then, the present remaining required charging capacity of the battery = 156AH-17.588AH = 138.412AH, and the remaining charging time is calculated as to be equal to 138.412AH/118A*SOH = 1.173H = 70.38min. If neither the present temperature of the battery nor the maximum cell voltage exceeds the above range, then the charging current remains unchanged, and the remaining charging time will gradually decrease based on 70.38 minutes, without frequent jumps.

If the battery temperature rises to the range where the maximum temperature is not lower than 43°C due to various factors during the charging process of the battery, the corresponding charging current is 51A*SOH, then a corresponding charging current is determined according to the present maximum cell voltage at this time, and the above steps are repeated again. Therefore, a new charging current required for charging the battery is obtained, and the new value is sent to the charging pile. When the charging pile charges the battery with the charging current, the battery management system starts to control the temperature until the temperature drops back to the range of [20°C, 40°C]. During a period in which the temperature of the battery falls back to the range of [20°C, 40°C] after rising to a maximum temperature of no less than 43°C, the charging pile will charge the battery with the new charging current, and naturally the remaining charging time is recalculated according to the aforementioned method. However, since the new charging current is still constant, the remaining charging time is still accurate, and gradually decreases according to the regularity, without frequent jumps. When the temperature of the battery drops back to the range of [20°C, 40°C], it is still necessary to re-determine the charging current according to this temperature range and the current maximum cell voltage, and the remaining charging time is still recalculated according to the aforementioned method. The charging current at this time is still constant, so the remaining charging time is still accurate, and gradually decreases according to the regularity, without frequent jumps.

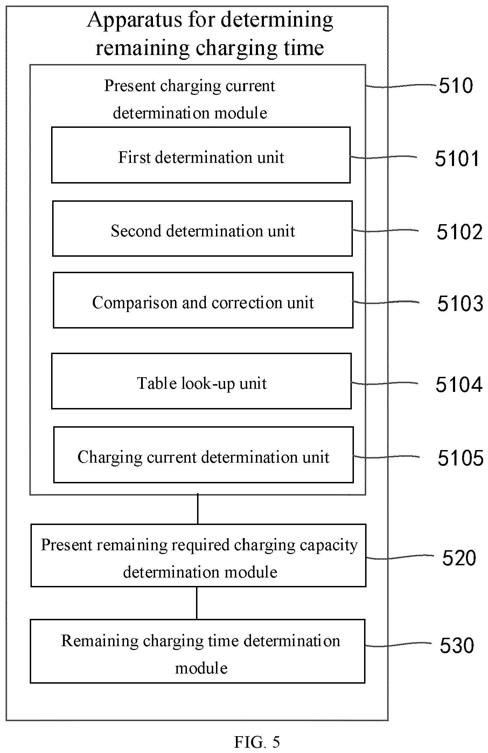

An embodiment of the present disclosure further provides an apparatus for determining the remaining charging time. Referring to FIG. 5, which is a block diagram illustrating an apparatus for determining remaining charging time provided by the embodiment of the present disclosure, the apparatus includes:
a present charging current determination module 510, configured to determine present charging current according to present temperature of a battery;
a present remaining required charging capacity determination module 520, configured to determine present remaining required charging capacity of the battery according to present available energy of the battery and a total capacity of the battery; and
a remaining charging time determination module 530, configured to determine the remaining charging time required by the battery according to the present remaining required charging capacity and the present charging current.

The present charging current determination module 510 includes:
a first determination unit 5101, configured to determine a first charging current according to the present temperature of the battery;
a second determination unit 5102, configured to determine a second charging current according to a present cell voltage of the battery;
a comparison and correction unit 5103, configured to compare the first charging current with the second charging current in terms of magnitudes, take a smaller one to be corrected to form a third charging current;
a table look-up unit 5104, configured to obtain a fourth charging current by looking up a maximum temperature and maximum cell voltage table according to the temperature of the battery; and
a charging current determination unit 5105, configured to compare the third charging current with the fourth charging current in terms of magnitudes, take a smaller one to be added with consumption current of a high-voltage accessory so as to obtain the present charging current.

Optionally, the present remaining required charging capacity determination module 520 includes:
a capacity calculation unit, configured to calculate a present available capacity of the battery according to the present available energy and the present voltage of the battery; and
a difference unit, configured to determine a difference between the total capacity and the present available capacity as the present remaining required charging capacity.

Optionally, the apparatus further includes:
a temperature range setting module, configured to set multiple temperature ranges according to an initial temperature of the battery; and
a temperature range current setting module, configured to set a corresponding first charging current for each of the temperature ranges;
wherein, for each of the temperature ranges lower than a preset temperature threshold, when the minimum temperature of the battery during charging rises to not lower than a corresponding first preset current value, the first charging current is changed to a fifth charging current; when the minimum temperature of the battery during charging drops to not higher than a corresponding second preset current value, the first charging current is changed to a sixth charging current;
wherein, for each of the temperature ranges higher than a preset temperature threshold, when the maximum temperature of the battery during charging rises to not lower than a corresponding third preset current value, the first charging current is changed to a seventh charging current; when the maximum temperature of the battery during charging drops to not higher than a corresponding fourth preset current value, the first charging current is changed to an eighth charging current.

Optionally, the apparatus further includes:
a voltage range setting module, configured to set multiple voltage ranges according to the maximum cell voltage of the battery; and
a voltage range current setting module, configured to set a corresponding second charging current for each of the voltage ranges;
wherein, when the maximum cell voltage of the battery during charging is lower than a corresponding first preset voltage value, the second charging current is changed to a ninth charging current;
when the maximum cell voltage of the battery during charging is not lower than the corresponding first preset voltage value and is lower than a second preset voltage value, the second charging current is changed to a tenth charging current;
when the maximum cell voltage of the battery is not lower than a preset voltage threshold, the second charging current is changed to zero.

Optionally, the temperature range setting module is further configured to set a starting temperature range, a special temperature range and a termination temperature range according to the initial temperature of the battery;
the temperature range current setting module is further configured to set a corresponding first charging current for the starting temperature range, the special temperature range and the termination temperature range respectively;
wherein, in the starting temperature range, if the minimum temperature of the battery is not lower than the corresponding fifth preset current value, the first charging current is changed to an eleventh charging current; if the minimum temperature of the battery is lower than the corresponding fifth preset current value, the first charging current is changed to zero;
in the special temperature range, if the maximum temperature of the battery is not lower than the corresponding sixth preset current value, the first charging current is changed to a twelfth charging current; if the minimum temperature of the battery is not higher than the corresponding seventh preset current value, the first charging current is changed to a thirteenth charging current;
in the termination temperature range, if the maximum temperature of the battery is not higher than the corresponding eighth preset current value, the first charging current is changed to a fourth charging current; if the maximum temperature of the battery is higher than the corresponding fifth preset current value, the first charging current is changed to zero.

An embodiment of the present disclosure further provides a vehicle, including: a vehicle controller; and the vehicle controller executes the method for determining remaining charging time described in any one of steps 101 to 103.

Through the above embodiments, the method for determining remaining charging time provided by the embodiments of the present disclosure comprehensively considers the factors of battery temperature and cell voltage, so that the upper limit value of the charging current under the factors of battery temperature and cell voltage will not be exceeded. Then the charging current under the factors of battery temperature and cell voltage is compared with a charging current obtained by looking up the table, and the smaller one is taken, and fast charging current is further refined. Therefore, the charging current value will not exceed the upper limit of the charging current under the battery temperature and single voltage factors while meeting the charging current requirements of the fast charging, and the charging current is a constant charging current. Since the present charging current is no longer a linear change but a constant charging current while meeting the requirements for fast charging current, compared with the remaining charging time obtained based on the linearly changing current, the accuracy of the remaining charging time required for the battery, which is determined according to the present remaining required charging capacity and the present charging current, is greatly improved. Moreover, as long as the present charging current remains unchanged, the remaining charging time will not change irregularly, nor will it change frequently, so that the user can accurately know the remaining charging time, which improves the user experience and has high practical value.

The apparatus embodiments described above are only illustrative, where the units described as separate components may or may not be physically separated, and the components shown as units may or may not be physical units, that is, they may be located in one place, or distributed to multiple network elements. Some or all of the modules may be selected according to actual needs to achieve the purpose of the solution in the embodiment. Those skilled in the art can understand and implement it without paying creative effort.

Various component embodiments of the present disclosure may be implemented in hardware, or in software modules running on one or more processors, or in a combination thereof. Those skilled in the art should understand that a microprocessor or a digital signal processor (DSP) may be used in practice to implement some or all functions of some or all components in the computing processing device according to the embodiments of the present disclosure. The present disclosure can also be implemented as an apparatus or apparatus program (e.g., computer program and computer program product) for performing a part or all of the methods described herein. Such a program realizing the present disclosure may be stored on a computer-readable medium, or may have the form of one or more signals. Such a signal may be downloaded from an Internet site, or provided on a carrier signal, or provided in any other form.

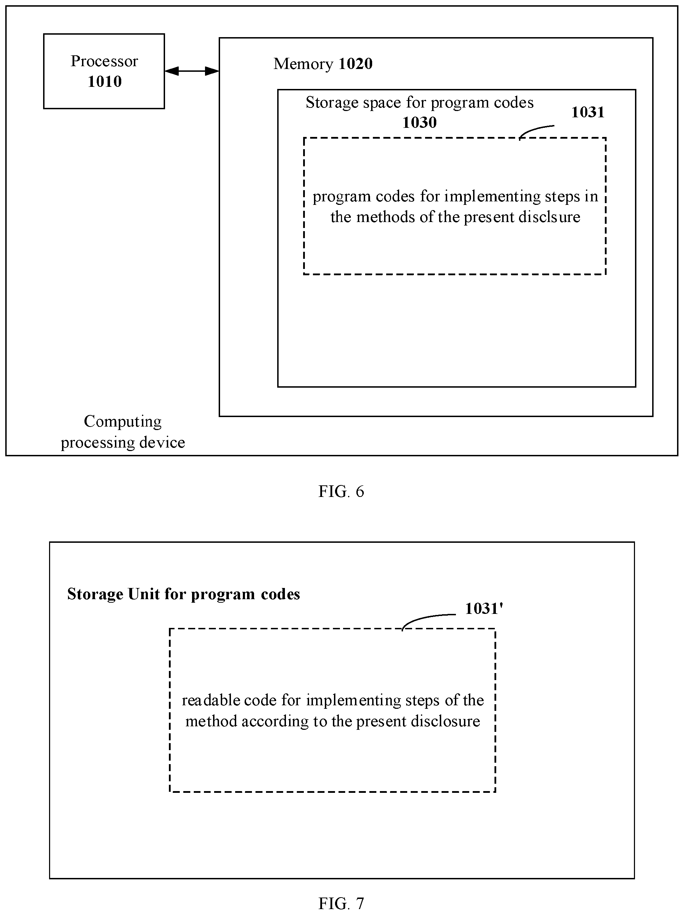

For example, FIG. 6 illustrates a computing processing device that may implement methods according to the present disclosure. The computing processing device conventionally includes a processor 1010 and a computer program product or computer readable medium in the form of memory 1020. The memory 1020 may be an electronic memory such as a flash memory, EEPROM (Electrically Erasable Programmable Read Only Memory), EPROM, hard disk, or ROM. The memory 1020 has a storage space 1030 storing program code 1031 for performing any method steps in the methods described above. For example, the storage space 1030 for program codes may include respective program codes 1031 for respectively implementing various steps in the above methods. These program codes can be read from or written into one or more computer program products. These computer program products include program code carriers such as hard disks, compact disks (CDs), memory cards or floppy disks. Such a computer program product is typically a portable or fixed storage unit as described with reference to FIG. 7. The storage unit may have storage segments, storage spaces, etc. arranged similarly to the memory 1020 in the computing processing device of FIG. 6. The program code can be compressed in a suitable form. Typically, the storage unit includes computer readable code 1031', i.e. code readable by a processor such as 1010, that, when executed by a computing processing device, causes the computing processing device to perform each step of the above methods.

It should be noted that, the terms "comprising", "including" or any other variation thereof as used herein are intended to cover a non-exclusive inclusion, such that a process, method, article or apparatus including a set of elements includes not only those elements, but also other elements not expressly listed, or elements inherent in the process, method, article, or apparatus. Without further limitations, an element defined by the phrase "comprising a ..." does not preclude the presence of additional identical elements in the process, method, article, or apparatus including that element.

The embodiments of the present disclosure have been described above in conjunction with the accompanying drawings, but the present disclosure is not limited to the above-mentioned specific implementations. The above-mentioned specific implementations are only illustrative and not restrictive. Under the inspiration of the present disclosure, without departing from the spirit of the present disclosure and the protection scope of the claims, many forms can also be made, and these forms all belong to the protection of the present disclosure.

## Claims

1. A method for determining remaining charging time, comprising:
determining present charging current according to a present cell voltage and a present temperature of a battery;
determining a present remaining required charging capacity of the battery according to present available energy of the battery and a total capacity of the battery; and
determining the remaining charging time required by the battery according to the present remaining required charging capacity and the present charging current;
wherein the determining present charging current according to a present cell voltage and a present temperature of a battery comprises:
determining a first charging current according to the present temperature of the battery;
determining a second charging current according to the present cell voltage of the battery;
comparing the first charging current with the second charging current in terms of magnitudes, taking and correcting a smaller one to form a third charging current;
obtaining a fourth charging current by looking up a maximum temperature and maximum cell voltage table according to the temperature of the battery; and
obtaining the present charging current by comparing the third charging current with the fourth charging current in terms of magnitudes, and taking and adding the smaller one to consumption current of a high-voltage accessory.

2. The method according to claim 1, wherein the determining a present remaining required charging capacity of the battery according to present available energy of the battery and a total capacity of the battery comprises:
calculating a present available capacity of the battery according to the present available energy and the present cell voltage of the battery; and
determining a difference between the total capacity and the present available capacity as the present remaining required charging capacity.

3. The method according to claim 1, wherein before determining a first charging current according to the present temperature of the battery, the method further comprises:
setting multiple temperature ranges according to an initial temperature of the battery; and
setting a corresponding first charging current for each of the temperature ranges;
wherein, for each of the temperature ranges lower than a preset temperature threshold, when a present minimum temperature of the battery during charging rises to not lower than a corresponding first preset current value, the first charging current is changed to a fifth charging current; when the present minimum temperature of the battery during charging drops to not higher than a corresponding second preset current value, the first charging current is changed to a sixth charging current;
wherein, for each of the temperature ranges higher than the preset temperature threshold, when a present maximum temperature of the battery during charging rises to not lower than a corresponding third preset current value, the first charging current is changed to a seventh charging current; when the present maximum temperature of the battery during charging drops to not higher than a corresponding fourth preset current value, the first charging current is changed to an eighth charging current.

4. The method according to claim 1, wherein before determining a second charging current according to the present cell voltage of the battery, the method further comprises:
setting multiple voltage ranges according to a maximum cell voltage of the battery; and
setting a corresponding second charging current for each of the voltage ranges;
wherein, when the present maximum cell voltage of the battery during charging is lower than a corresponding first preset voltage value, the second charging current is changed to a ninth charging current;
when the present maximum cell voltage of the battery during charging is not lower than the corresponding first preset voltage value and is lower than a second preset voltage value, the second charging current is changed to a tenth charging current;
when the present maximum cell voltage of the battery is not lower than a preset voltage threshold, the second charging current is changed to zero.

5. The method according to claim 1, further comprising:
setting a starting temperature range, a special temperature range and a termination temperature range according to the initial temperature of the battery; and
setting a corresponding first charging current for the staring temperature range, the special temperature range and the termination temperature range respectively;
wherein, in the starting temperature range, if the present minimum temperature of the battery is not lower than a corresponding fifth preset current value, the first charging current is changed to an eleventh charging current; if the present minimum temperature of the battery is lower than the corresponding fifth preset current value, the first charging current is changed to zero;
in the special temperature range, if the present maximum temperature of the battery is not lower than a corresponding sixth preset current value, the first charging current is changed to a twelfth charging current; if the present minimum temperature of the battery is not higher than a corresponding seventh preset current value, the first charging current is changed to a thirteenth charging current;
in the termination temperature range, if the present maximum temperature of the battery is not higher than a corresponding eighth preset current value, the first charging current is changed to a fourteenth charging current; if the present maximum temperature of the battery is higher than the corresponding eighth preset current value, the first charging current is changed to zero.

6. An apparatus for determining remaining charging time, comprising:
a present charging current determination module, configured to determine present charging current according to a present cell voltage and a present temperature of a battery;
a present remaining required charging capacity determination module, configured to determine a present remaining required charging capacity of the battery according to present available energy of the battery and a total capacity of the battery; and
a remaining charging time determination module, configured to determine the remaining charging time required by the battery according to the present remaining required charging capacity and the present charging current.
wherein the present charging current determination module comprises:
a first determination unit, configured to determine a first charging current according to the present temperature of the battery;
a second determination unit, configured to determine a second charging current according to a present cell voltage of the battery;
a comparison and correction unit, configured to compare the first charging current with the second charging current in terms of magnitudes, take and correct a smaller one to form a third charging current;
a table look-up unit, configured to obtain a fourth charging current by looking up a maximum temperature and maximum cell voltage table according to the temperature of the battery; and
a charging current determination unit, configured to obtain the present charging current by comparing the third charging current with the fourth charging current in terms of magnitudes, and taking and adding a smaller one with consumption current of a high-voltage accessory.

7. The apparatus according to claim 6, wherein the present remaining required charging capacity determination module comprises:
a capacity calculation unit, configured to calculate a present available capacity of the battery according to present available energy and the present cell voltage of the battery; and
a difference unit, configured to determine a difference between the total capacity and the present available capacity as the present remaining required charging capacity.

8. The apparatus according to claim 6, further comprising:
a temperature range setting module, configured to set multiple temperature ranges according to an initial temperature of the battery; and
a temperature range current setting module, configured to set a corresponding first charging current for each of the temperature ranges;
wherein, for each of the temperature ranges lower than a preset temperature threshold, when the present minimum temperature of the battery during charging rises to not lower than a corresponding first preset current value, the first charging current is changed to a fifth charging current; when the present minimum temperature of the battery during charging drops to not higher than a corresponding second preset current value, the first charging current is changed to a sixth charging current;
wherein, for each of the temperature ranges higher than the preset temperature threshold, when the present maximum temperature of the battery during charging rises to not lower than a corresponding third preset current value, the first charging current is changed to a seventh charging current; when the present maximum temperature of the battery during charging drops to not higher than a corresponding fourth preset current value, the first charging current is changed to an eighth charging current.

9. The apparatus according to claim 6, further comprising:
a voltage range setting module, configured to set multiple voltage ranges according to a maximum cell voltage of the battery; and
a voltage range current setting module, configured to set a corresponding second charging current for each of the voltage ranges;
wherein, when the present maximum cell voltage of the battery during charging is lower than a corresponding first preset voltage value, the second charging current is changed to a ninth charging current;
when the present maximum cell voltage of the battery during charging is not lower than the corresponding first preset voltage value and is lower than a second preset voltage value, the second charging current is changed to a tenth charging current;
when the present maximum cell voltage of the battery is not lower than a preset voltage threshold, the second charging current is changed to zero.

10. A vehicle, comprising a vehicle controller,
wherein the vehicle controller executes the method for determining remaining charging time according to any one of claims 1-5.

11. A computing processing device, comprising:
a memory storing with computer readable codes; and
one or more processors, when the computer readable codes are executed by the one or more processors, the computing processing device executes the method for determining remaining charging time according to any one of claims 1-5.

12. A computer program, comprising computer readable codes that, when run on a computing processing device, cause the computing processing device to perform the method for determining remaining charging time according to any one of claims 1-5.

13. A computer readable medium, wherein the computer program according to claim 12 is stored in the computer readable medium.
